# EUROPEAN PATENT APPLICATION

(11) **EP 1 747 830 A1**
(43) Date of publication of application: **31.01.2007**
(21) Application number: 05737035.5
(22) Date of filing: 26.04.2005
(51) Int. Cl.: B22F 1/00, B22F 1/02, B22F 9/24, H01B 1/02, H01B 1/22, H01B 13/00

(54) **FLAKY COPPER POWDER, PROCESS FOR PRODUCING THE SAME, AND CONDUCTIVE PASTE**

(30) Priority: 28.04.2004 JP 2004134689
(71) Applicant: Mitsui Mining and Smelting Co., Ltd, Shinagawa-ku, Tokyo 141-8584 (JP)
(72) Inventor: SAKAUE, Takahiko, c/oHikoshima Smelting Co., Ltd., Shimonoseki-shi, Yamaguchi (JP); YOSHIMARU, Katsuhiko, Hikoshima Smelting Co., Ltd, Shimonoseki-shi, Yamaguchi (JP); NAKAMURA, Yoshinobu, Hikoshima Smelting Co., Ltd., Shimonoseki-shi, Yamaguchi (JP); SHIMAMURA, Hiroyuki, Hikoshima Smelting Co., Ltd., Shimonoseki-shi, Yamaguchi (JP)
(74) Representative: Bohmann, Armin K.
(86) International application number: PCT/JP2005/007877
(87) International publication number: WO 2005/105345

(57) **Abstract**

It is an object of the present invention to provide a flaky copper powder composed of fine particles having a sharp distribution particle size, a large crystallite diameter and high oxidation resistance. The flaky copper powder of the present invention contains P and has a crystallite diameter/D_{1A} ratio of 0.01 or more to achieve the object. The method for producing the flaky copper powder comprises four steps: a first step of preparing an aqueous solution containing a copper salt and complexing agent; a second step of adding an alkali hydroxide to the aqueous solution to prepare a first slurry containing cupric oxide; a third step of adding a first reducing agent which can reduce the cupric oxide into cuprous oxide to the first slurry to prepare a second slurry containing cuprous oxide; and a fourth step of adding a second reducing agent which can reduce the cuprous oxide into copper to the second slurry to provide a flaky copper powder, wherein phosphoric acid and its salt are added in at least one of the first to third steps and/or in the second slurry in the fourth step.

## Description

### Technical Field

The present invention relates to a flaky copper powder, a method for producing the same and a conductive paste. More specifically a flaky copper powder useful as a raw material for a copper paste which is used for securing electrical continuity of electrical circuits on printed circuit substrate and external electrodes of ceramic condensers and the like, a method for producing the same and a conductive paste.

### Background Art

One of the convertible methods for forming electrodes or circuits in an electronic device or the like is, that printing a conductive paste in which a copper powder is dispersed as a conductive material on a substrate and then hardening by calcining or curing the paste to obtain electrodes or circuits.

Recently, as the markets have required downsizing and higher density for electronic devices for multi functional electronic devices, so, a copper powder for a conductive paste is required to have distribution sharper in particle size with finer size so that it gives a well filling ability conductive paste.

A copper powder for a conductive paste may be oxidized on contacting oxygen, e.g., in evaporation of volatile contents from the conductive paste at the calcining, in particular. Copper oxidation is an undesirable phenomenon, because it leads high resistance of a thick copper film when it is used as conductive paste. Therefore, the copper powder is preferred to have excellent resistance to oxidation. It is said that the resistance can be enhanced by increasing a diameter to decrease a grain boundaries of crystallites in the powder. Therefore it is preferable to increase the diameter of the crystallite in the copper powder as large as possible.

One of a substrate on which a conductive paste is printed is a ceramic material, for use of IC packages, where large quantities of heat are generated. However, a ceramic substrate generally differs in thermal expansion rate coefficient from a thick copper film formed with a conductive paste, with the result that troubles, e.g., separation of the film from the substrate and deformation of the substrate itself, may occur when the paste is printed on the substrate at the calcinations process. Therefore, thermal expansion values are preferably as close to each other as possible.

One of the causes for thermal expansion of the thick copper film by the calcinations may be minimized space of the copper particles with each other by sintering, which are left between the copper particles in evaporation of volatile contents from the conductive paste. It is therefore necessary to minimize the spaces remaining among the copper particles as small as possible in order to have a copper-containing conductive paste of low thermal expansion values. In other words, the copper particles preferably have a shape which makes it easy to fill the paste densely. It is also preferable that the copper particles in the conductive paste have a shape which increases contact area between them to improve conductivity of the thick copper film prepared by calcinating the conductive paste. Particle shape anisotropy decreases as it increases sphericity, or increases as it becomes flatter. Therefore, a flaky copper powder instead of spherical one has been studied to meet the copper particle requirements.

Moreover, a flaky copper powder preferably has a sharper distribution particle size to be more dispersible in paste for a conductive paste.

As discussed above, copper powder, in particular flaky copper powder, for conductive paste is preferably finer, sharper distribution in particle size and larger in crystallite diameter.

Patent Document 1 (Japanese Patent Laid-Open No. 2003-119501) discloses flaky copper powder having the following characteristics; particle diameter: 10 µm or less, SD/D₅₀ ratio: 0.15 to 0.35 (where, SD is standard deviation of particle size distribution and D₅₀ is 50% volumetric cumulative particle diameter), and aspect ratio: 0.3 to 0.7 (i.e., ratio of thickness of particles which constitute the powder to D₅₀). The invention gives a flaky copper powder composed of fine, flat and flaky particles.

[Patent Document 1]: Japanese Patent Laid-Open No. 2003-119501 (Page 2)

### Disclosure of the Invention

However, the flaky copper powder disclosed by Patent Document 1, although fine, is produced by breaking agglomerated copper particles and then deforming the broken particles by compression in a high-energy ball mill. As a result, it involves problems that it tends to be oxidized or strained during the compression deformation step and to have small crystallite diameter.

It is therefore an object of the present invention to provide a flaky copper powder composed of fine particles, having a sharp distribution particle size, a large crystallite diameter and high oxidation resistance. It is another object to provide a conductive paste using the flaky copper powder.

The inventors of the present invention have found, after having extensively studied to solve the above problems under these situations, that a P-containing flaky copper powder, in particular that composed of particles of specific shape, is suitable for a conductive paste. The inventors have also found that a flaky copper powder composed of small particle diameter, a large crystallite diameter, and high oxidation resistance, a sharp distribution particle size, can be produced without having to employ compression deformation treatment, like the method disclosed by Patent Document 1, by a wet process, adding a specific phosphoric acid and its salt in at least one of the steps, comprising a plurality of steps for reducing the copper ion (II) present in a copper salt in a raw material, achieving the present invention.

Thepresent invention provides a flaky copper powder which is characterized in that comprising P.

The present invention also provides a flaky copper powder which is characterized in that comprising P at 10 to 200 ppm (D₅₀ is a median diameter (µm) calculated as 50% of volume cumulative distributions examined by a laser diffraction scattering particle size distribution measuring method).

The flaky copper powder of the present invention preferably has an average particle diameter D₅₀ of the powder is in the range from 0.3 to 7 µm.

In addition, the flaky copper powder of the present invention preferably has a crystallite diameter of the powder is 25 nm or more.

The flaky particles which constitute the flaky copper powder of the present invention preferably have an aspect ratio (D_{1A}/t), obtained by dividing an aspect ratio D_{1A}/t of the powder, which is calculated by dividing an average particle diameter D_{1A} (µm) by a flaky copper particle thickness t (µm), the average particle diameter D_{1A} (µm) and the thickness t (µm) are measured from analyzing SEM images directly observed by a scanning electron microscope, is in the range from 2 to 50.

Moreover, the f laky copper powder of the present invention preferably has an SD/D₅₀ ratio of 0.45 or less, where D₅₀ is a median diameter (µm) calculated as 50% of volume cumulative distributions examined by a laser diffraction scattering particle size distribution measuring method.

Still more, the flaky copper powder of the present invention preferably has a D₉₀/D₁₀ ratio of 3.0 or less, where D₁₀ is diameter (µm) at 10% of volume cumulative distributions and D₉₀ is diameter (µm) at 90% of volume cumulative distributions examined by a laser diffraction scattering particle size distribution measuring method, respectively, and SD is a standard deviation (µm) of a particle size distribution examined by the same measuring method.

As a method of the present invention for producing a flaky copper powder, a method comprising four steps: a first step of preparing an aqueous solution comprising a copper salt and a complexing agent; a second step of adding an alkali hydroxide to the aqueous solution to prepare a first slurry comprising cupric oxide; a third step of adding a first reducing agent which can reduce cupric oxide into cuprous oxide to the first slurry to prepare a second slurry comprising cuprous oxide; and a fourth step of adding a second reducing agent which can reduce the cuprous oxide into copper to the second slurry to provide a flaky copper powder, which is characterized in that phosphoric acid and its salt are added in at least one of the first to third steps and/or phosphoric acid and its salt are added in the second slurry in the fourth step is preferably adopted.

In the method of the present invention for producing the flaky copper powder, which is characterized in that the phosphoric acid and its salt are added in at least one of the first to third steps and/or in the second slurry in the fourth step preferably to be a total amount of 0.001 to 3 moles as P per 1 mole of copper which present in the above described aqueous solution, the first slurry or the second slurry.

Moreover, in the method of the present invention for producing the flaky copper powder, the first slurry preferably contains 1.05 to 1.50 chemical equivalents of the alkali hydroxide against one chemical equivalent of the copper salt.

Still more, in the method of the present invention for producing the flaky copper powder, the complexing agent is preferably an amino acid.

Still more, in the method of the present invention for producing the flaky copper powder, the first reducing agent is preferably a reducing sugar.

Still more, in the method of the present invention for producing the flaky copper powder, the second reducing agent is preferably at least one selected from the group consisting of hydrazine, hydrated hydrazine, hydrazine sulfate, hydrazine carbonate and hydrazine chloride.

Still more, in the method of the present invention for producing the flaky copper powder, the aqueous solution preferably comprises the complexing agent at 0. 005 to 10 moles per 1 mole of copper present in the aqueous solution itself, first slurry or second slurry.

The method of the present invention provides the flaky copper powder characterized in that an organic surface treatment layer is formed on the surface.

Moreover, the method of the present invention provides the flaky copper powder characterized in that a coating rate of the organic surface treatment layer is 0.05 to 2wt% based on the flaky copper powder.

The present invention also provides a method for producing a conductive paste characterized by comprising the flaky copper powder of the present invention and a resin.

### Advantage of the Invention

The flaky copper powder is free from compression deformation process. It is less oxidized or strained, fine, sharp distribution in particle size, and has a large crystallite diameter. As such, when used for a conductive paste, the powder is resistant to oxidation in evaporation of volatile contents process from the conductive paste, well dispersible in the paste, and densely fills the conductive paste can downsize of electrodes, circuits or the like formed by a thick copper film. The method of the present invention can efficiently produce the flaky copper powder of the present invention. The conductive paste of the present invention is highly oxidation-resistant in evaporation of volatile contents process from the conductive paste; densely filled with the flaky copper powder; electrodes, circuits and or the like by a thick copper film can be finer; and a thick copper film can be excellent thermal expansion rate.

### Best Mode for Carrying Out the Invention

### (Flaky copper powder of the present invention)

The flaky copper powder of the present invention is composed of particles of microscopically flaky shape. In the present invention, the powder of flaky shape means that the primary particles have a flaky shape and does not mean shape of the secondary particles, i.e., agglomerated primary particles.

The flaky copper powder of the present invention normally has a D₅₀ value of 0.3 to 7 µm, preferably 0.5 to 5 µm, more preferably 0.5 to 4 µm. The flaky copper powder having a D₅₀ value in the above range is preferable, because it well fills the conductive paste. On the other hand, the powder having a D₅₀ value below 0.3 µm is not preferable, because it gives the conductive paste of excessively high viscosity, and the powder having a D₅₀ value above 7 µm is also not preferable, because it is difficult to make thinner of the thick copper film or produce a fine line with the conductive paste. In the present invention, D₁₀, D₅₀ and D₉₀ are diameter (µm) at 10, 50 and 90% by volume cumulative distributions examined by a laser diffraction scattering particle size distribution measuring.

The flaky copper powder of the present invention has a crystallite diameter of 25 nm or more, preferably 35 nm or more. It is preferable that a crystallite diameter is within the above-described range, because it gives a conductive paste suffering to a small dimensional change in a thick copper film forming process, the dimensional changes leading thermal expansion rate more notably to separate the film from a ceramic substrate or deformation of the film, and, moreover, it exhibits higher oxidation resistance in evaporation of volatile contents process. On the other hand, it is not preferable that a crystallite diameter below 25 nm, because it gives a conductive paste more suffering troubles resulting from dimensional changes in a thick copper film forming process, the dimensional changes causing thermal expansion rate more notably to separate the film from a ceramic substrate or deformation of the film, and, moreover, it exhibits lower oxidation resistance in evaporation of volatile contents process. The crystallite diameter in this specification means the average crystallite diameter obtained from the half-value width of the diffraction angle of each crystal face obtained by conducting X-ray diffraction for flaky copper powder sample.

The crystallite diameter/D_{1A} ratio of the flaky copper powder of the present invention is normally 0.01 or more, preferably 0.015 or more. The crystallite diameter/D_{1A} within the above-described range is preferable because it gives small dimensional changes in a thick copper film, which is produced with the paste contained the flaky copper powder, forming process, the dimensional changes causing thermal expansion rate more notably. And, moreover, it exhibits higher oxidation resistance in evaporation of volatile contents process. On the other hand, the powder having the crystallite diameter/D_{1A} ratio below 0.01 is not preferable, because it gives a conductive paste suffering troubles resulting from dimensional changes in a thick copper film forming process by the paste, the dimensional changes causing thermal expansion rate more notably. And, moreover, it exhibits lower oxidation resistance in evaporation of volatile contents process.

The flaky copper powder of the present invention normally has a D_{1A} value of 0.3 to 8 µm. The flaky copper powder having a D_{1A} value in the above range is preferable, because it gives high densely the conductive paste. On the other hand, the flaky copper powder having a D_{1A} value below 0.3 µm is not preferable, because it gives the conductive paste of excessively high viscosity, and the powder having a D_{1A} value above 8 µm is also not preferable, because it is difficult to thinner of the thick copper film or produce a fine line with the conductive paste in which it is added. The D_{1A} value in this specification is an average major diameter (µm) observed by a scanning electron microscope (SEM, magnification: 5,000 to 20,000) for 10 or more flaky copper particle samples, and differs from the D₅₀ value, which is a 50% volumetric cumulative particle diameter (µm) determined by laser diffraction-scattering particle size distribution measuring method.

The flaky copper powder of the present invention normally has an aspect ratio D_{1A}/t, i.e., D_{1A} divided by thickness t (µm) of the flaky copper powder, of 2 to 50, preferably 2 to 20, more preferably 3 to 10. The powder having the aspect ratio D_{1A}/t in the above range is preferable, because it has an increased contact area between the copper particles in the conductive paste and tends to decrease electrical resistance of the thick copper film prepared with the paste. On the other hand, the powder having an aspect ratio (D_{1A}/t) below 2 has an insufficient contact area between the copper particles in the conductive paste and tends to be difficult to decrease thick copper film resistance, and that having the ratio above 50 tends to rapidly increase viscosity of the conductive paste. Thickness t (µm) of the flaky copper powder used in this specification is an average value determined by processing SEM images directly observed by a scanning electron microscope .

The flaky copper powder of the present invention contains P normally at 10 to 200 ppm, preferably 30 to 100 ppm, more preferably 50 to 80 ppm. The powder containing P at a content in the above range is preferable, because it tends to have higher oxidation resistance. The content beyond the above range is not preferable; because the powder may be insufficient in oxidation resistance and difficult to be flattened at below 10 ppm, and tends to have an excessive resistance at above 200 ppm. The "ppm" used in this specification means parts per million by weight.

The flaky copper powder of the present invention normally has an SD/D₅₀ ratio of 0.45 or less, preferably 0.4 or less. The flaky copper powder having an SD/D₅₀ ratio in the above range is preferable, because it shows the flaky copper powder having a sharp distribution particle size so that the conductive paste in which it is added tend to be high densely The flaky copper powder having an SD/D₅₀ ratio beyond the above range is not preferable, because it shows the flaky copper powder having a broader particle size distribution, hence insufficiently filling the conductive paste in which it is added. SD used in this specification is a standard deviation (µm) of the particle size distribution, examined by a laser diffraction-scattering particle size distribution laser diffraction scattering particle size distribution measuring method.

The flaky copper powder of the present invention normally has a D₉₀/D₁₀ ratio of 3.0 or less, preferably 2.5 or less. The flaky copper powder having a D₉₀/D₁₀ ratio beyond the above range is not preferable, because it shows the flaky copper powder having a broader distribution particle size and hence the conductive paste tends to be insufficiently filling.

The flaky copper powder of the present invention normally has a specific surface area of 0.2 to 4.0 m²/g, preferably 0.3 to 2.2 m²/g. The powder having a specific surface area above 4.0 m²/g is not preferable, because it may gives an excessively viscous conductive paste. The specific surface area in this specification is BET-determined one.

The flaky copper powder of the present invention normally has a tap density of 2.0 g/cm³ or more, preferably 3.3 to 5.0 g/cm³. The powder having a tap density in the above range is preferable, because it is well dispersible in a paste thus easy production of a conductive paste. Moreover, space formed adequately among flaky copper powder during formation of a conductive paste film may ease evaporate of a volatile contents from the conductive paste film, and thereby to increase density of the calcined film and hence decrease electrical resistance of the resulting thick copper film.

The flaky copper powder of the present invention is preferably surface-treated to have an organic layer on the particles, because it is protected from oxidation with oxygen in a calcination atmosphere while the conductive paste film in which it is added is calcined to form a thick copper film, and thereby to prevent temporal increase of electrical resistance of the film.

The organic surface layer is formed by coating the flaky copper powder particles with an organic compound. The organic compounds useful for the present invention can be selected from saturated fatty acids, unsaturated fatty acids, nitrogen-containing organic compounds, sulfur-containing organic compounds and silane coupling agents or the like.

The saturated fatty acids useful for the present invention can be selected from enanthic acid (C₆H₁₃COOH), caprylic acid (C₇H₁₅COOH), pelargonic acid (C₈H₁₇COOH), capric acid (C₉H₁₉COOH), undecylic acid (C₁₀H₂₁COOH), lauric acid (C₁₁H₂₃COOH), tridecylic acid (C₁₂H₂₅COOH), myristic acid (C₁₃H₂₇COOH), pentadecylic acid (C₁₄H₂₉COOH), palmitic acid (C₁₅H₃₁COOH), heptadecylic acid (C₁₆H₃₃COOH), stearic acid (C₁₇H₃₅COOH), nonadecanoic acid (C₁₈H₃₇COOH), arachidic acid (C₁₉H₃₉COOH) and behenic acid (C₂₁H₄₃COOH) or the like.

The unsaturated fatty acids useful for the present invention can be selected from acrylic acid (CH₂=CHCOOH), crotonic acid (CH₃CH=CHCOOH), isocrotonic acid (CH₃CH=CHCOOH), undecylenic acid (CH₂=CH(CH₂)₉COOH), oleic acid (C₁₇H₃₃COOH), elaidic acid (CH₃(CH₂)₇CH=CH(CH₂)₇COOH), cetoleic acid (CH₃(CH₂)₉CH=CH(CH₂)₉COOH), blassidic acid (C₂₁H₄₁COOH), erucic acid (C₂₁H₄₁COOH), sorbic acid (C₅H₇COOH), linoleic acid (C₁₇H₃₁COOH), linolenic acid (C₁₇H₂₉COOH), and arachidonic acid (C₁₃H₃₁COOH) or the like.

The nitrogen-containing organic compounds useful for the present invention can be selected from triazole compounds having a substituent, e.g., 1,2,3-benzotriazole, carboxybenzotriazole, N',N'-bis(benzotriazolylmethyl)urea, 1H-1,2,4-triazole and 3-amino-1H-1,2,4-triazole or the like.

The sulfur-containing organic compounds useful for the present invention can be selected from mercaptobenzothiazole, thiocyanuric acid and 2-benzimidazolethiol or the like.

The silane coupling agents useful for the present invention can be selected from vinyl trimethoxysilane, aminosilane, tetramethoxysilane, methyltrimethoxysilane and diphenyldimethoxysilane or the like.

In the present invention, the above organic compounds, oleic acid, capric acid and stearic acid are more preferable, because they tend to give the flaky copper powder having higher oxidation resistance and more densely filling the conductive paste in which it is added. In the present invention, these organic compounds, i.e., saturated fatty acids, unsaturated fatty acids, nitrogen-containing organic compounds, sulfur-containing organic compounds and silane coupling agents, may be used either individually or in combination of two or more.

The flaky copper powder of the present invention, when surface-treated to have the surface organic layer on the particles, is normally coated at a coating rate of 0.05 to 2wt% on the flaky copper powder, preferably 0.1 to 1wt%. The coating rate of the organic surface layer used in this specification means ratio of weight of the surface organic layer to that of the uncoated flaky copper particles. The powder coatedat a rate in the above range is preferable, because it improves oxidation resistance of the conductive paste in which it is added, and tends to improve oxidation resistance of the powder itself. On the other hand, the powder coated at a rate above 2wt% is not preferable, because it tends to deteriorate temporal viscosity stability of the conductive paste.

The flaky copper powder of the present invention, when coated with the surface organic layer, normally has a specific surface area of 0.1 to 3.5 m²/g, preferably 0.2 to 2.0 m²/g. The powder having a specific surface area above 3.5 m²/g is not preferable, because it gives an excessively viscous conductive paste.

The flaky copper powder of the present invention, when coated with the surface organic layer, normally has a tap density of 3.0 g/cm³ or more, preferably 3.5 to 5.5 g/cm³. The powder having a tap density in the above range is preferable, because it is well dispersible in the paste thus make it easy production of the conductive paste. Moreover, it makes spaces adequately in a printed paste, and thereby to help evaporation of volatile contents from the conductive paste when the film is calcined and thereby to make well density of the calcined film and hence decrease electrical resistance of the resulting thick copper film. The flaky copper powder of the present invention can be produced by the following method, for example.

### (Method for forming the flaky copper powder of the present invention)

The method for forming a flaky copper powder of the present invention comprises four steps; the first step prepares an aqueous solution containing a copper salt and complexing agent (hereinafter referred to as aqueous copper salt solution); the second step an alkali hydroxide add to the aqueous solution to prepare a first slurry containing cupric oxide; the third step a first reducing agent which can reduce the cupric oxide into cuprous oxide add to the first slurry to prepare a second slurry containing cuprous oxide; and the fourth step a second reducing agent which can reduce the cuprous oxide add to the second slurry to obtain the copper of flaky shape, wherein phosphoric acid and its salt are added in at least one of the first to third steps and/or in the second slurry in the fourth step.

### (First step)

First, the first step prepares an aqueous copper salt solution. The aqueous copper salt solution in this invention is the aqueous solution prepared by adding a copper salt and complexing agent, where the copper ion (II) derived from the copper sal t is bound to the complexing agent to forma Cu complex.

The copper salts useful for the present invention can be selected from those soluble in water, e.g., copper sulfate, copper nitrate, copper acetate and a hydrate thereof, of which copper sulfate pentahydrate and copper nitrate are more preferable, because they are highly soluble as a salt gives high copper content and easy to make the flaky copper powder composed of the uniformly-sized particles. The complexing agents for the present invention are those reacting with the copper ion present in the aqueous solution. In the present invention, the Cu complex with the copper ion (II) derived from the copper salt works to uniformly produce CuO in the presence of an alkali hydroxide in the second step. The complexing agents can be use amino acid and tartaric acid or the like. The amino acids can be use aminoacetic acid, alanine, glutamic acid and or the like, of which aminoacetic acid is more preferable because it tends to give the uniformly-sized flaky copper powder. These complexing agents may be used either individually or in combination of two or more.

The aqueous copper salt solution is prepared by dissolving a copper salt and complexing agent in water. The procedure and order of dissolving them in water are not limited. For example, a copper salt and complexing agent are added to water kept stirred, and the resulting mixture is stirred. Water for the solution is preferably pure water, ion-exchanged water, superpure water or the like because it dissolves fine flaky copper particles and helps large crystallite diameter. When the solution is prepared, water is normally kept at 50 to 90°C, preferably 60 to 80°C. Keeping water at a temperature in the above range is preferable, because it makes easily production of theuniformly-sized copper oxide particles in the subsequent step.

The aqueous copper salt solution is added with a complexing agent normally at 0.005 to 10 moles per 1 mole of copper present in the solution, preferably 0.01 to 5 moles. The complexing agent added at content in the above range is preferable, because it gives the fine flaky copper particles of large crystallite diameter and high flatness.

The aqueous copper salt solution is added with a copper salt normally at 10 to 50 parts by weight per 100 parts by weight of water, preferably 20 to 40 parts by weight. The copper salt added at content in the above range is preferable, because it gives the highly uniformly-sized flaky copper particles.

### (Second step)

The second step adding the aqueous copper salt solution with an alkali hydroxide to prepare a first slurry containing cupric oxide. The first slurry for the present invention is a slurry prepared by adding an alkali hydroxide in the aqueous copper salt solution, in which fine particles of cupric oxide (CuO) of precipitate in the solution. An alkali hydroxide may be added in the form of an aqueous solution in the aqueous copper salt solution kept stirred, the resulting solution being continuously stirred, for example. While the first slurry is prepared, the solution is normally kept at 50 to 90°C, preferably 60 to 80°C. Keeping the solution at a temperature in the above range is preferable, because it facilitates production of the highly uniformly-sized flaky copper particles, with the primary particles being efficiently prevented from agglomerating with each other.

The alkali hydroxide for the present invention functions to convert copper in the complex present in the aqueous copper salt solution into cupric oxide (CuO). The alkali hydroxides useful for the present invention can be used sodium hydroxide, potassium hydroxide, ammonia, ammonia water and or the like, of which sodium hydroxide is more preferable because it is inexpensive and can easily control the reaction for forming cupric oxide. An alkali hydroxide is preferable because it helps, when kept in the form of aqueous solution, convert copper in the complex present in the aqueous solution into cupric oxide (CuO), when added in the solution, to reduce variations of the flaky copper particle diameters.

The first slurry is added with the alkali hydroxide normally at 1.05 to 1.50 equivalents per equivalent of the copper salt, preferably 1.10 to 1.30 equivalents. The alkali hydroxide present at content in the above range is preferable, because it facilitates production of the highly uniformly-sized flaky copper particles. Moles of the copper salt and alkali hydroxide are moles as acid and base, respectively.

In the second step, the first slurry is stirred normally for 10 to 60 minutes, preferably 20 to 40 minutes, after it is prepared by adding the aqueous copper salt solution with an alkali hydroxide. Continued stirring of the solution added with the alkali hydroxide is preferable, because it sufficiently converts copper in the complex present in the aqueous copper salt solution into cupric oxide (CuO), thereby can be produce of the highly uniformly-sized flaky copper particles.

### (Third step)

The third step incorporates the first slurry with a first reducing agent which can reduce the cupric oxide into cuprous oxide to prepare a second slurry containing cuprous oxide. The second slurry for the present invention is a slurry prepared by adding the first reducing agent in the first slurry, in which cuprous oxide (CuO) separates out in the solution. The first reducing agent may be added in the first slurry kept stirred, the resulting solution being continuously stirred. While the second slurry is prepared, the solution is normally kept at 50 to 90°C, preferably 60 to 80°C. Keeping the solution at a temperature in the above range is preferable, because it can be produce of the highly uniformly-sized flaky copper particles, with the primary particles being efficiently prevented from agglomerating with each other.

The first reducing agent for the present invention functions to reduce cupric oxide (CuO) present in the first slurry into cuprous oxide (Cu₂O). The first reducing agents for the present invention can be use reducing sugar and hydrazine or the like. The reducing sugars can be use glucose, fructose, lactose or the like, of which glucose is more preferable because it can control the reaction more easily. The above compounds may be used either individually or in combination of two or more. The first reducing agent is preferable because it helps, when kept in the form of aqueous solution, quickly reduce cupric oxide (CuO) present in the first slurry into cuprous oxide (Cu₂O), when added in the first slurry, to reduce variations of the flaky copper particle diameter.

The second slurry is added with the first reducing agent normally at 0.1 to 3.0 moles per 1 mole of the copper salt present in the first slurry, preferably 0.3 to 1.5 moles. The first reducing agent present at a content in the above range is preferable, because it allows the reduction of cupric oxide (CuO) into cuprous oxide (Cu₂O) to proceed sufficiently, thus facilitating synthesis of the flaky copper powder with the primary particles agglomerating with each other to a lesser extent.

In the third step, the second slurry is stirred normally for 10 to 60 minutes, preferably 20 to 40 minutes, after it is prepared by adding the first reducing agent in the first slurry. It is preferred to stir the solution after adding the alkali hydroxide is preferable, because it sufficiently reduces cupric oxide (CuO) into cuprous oxide (Cu₂O), thus can make a synthesis of the flaky copper powder wi th the primary particles agglomerating with each other to a lesser extent.

### (Fourth step)

The fourth step adds a second reducing agent which can reduce the cuprous oxide into copper to the second slurry for producing flaky copper powder. In the present invention, phosphoric acid and its salt are added in at least one of the first to third steps and/or in the second slurry in the fourth step. Therefore, the second slurry invariably contains phosphoric acid and its salt when the second reducing agent is added in the fourth step.

The phosphoric acid and its salt for the present invention are those capable of supplying the phosphate ion, e.g., orthophosphate, pyrophosphate, metaphosphate ion or the like in the presence of water. It is considered that P added by them in the flaky copper power of the present invention functions to decrease copper particle diameter and increase crystallite diameter. The phosphoric acids and the salts thereof useful for the present invention can be selected from phosphoric acid; polyphosphoric acids, e.g., pyrophosphoric acid; metaphosphoric acids, e.g., trimetaphosphoric acid; phosphates, e.g., sodium phosphate and potassium phosphate; polyphosphates, e.g., sodium pyrophosphate and potassium pyrophosphate; and metaphophates, e.g., sodium trimetaphophate and potassium trimetaphosphate or the like.

The total quantity of the phosphoric acid and its salt added in at least one of the first to third steps and/or in the second slurry in the fourth step is normally 0.001 to 3 moles as P (phosphorus) per mole of copper present in the aqueous copper salt solution or first or second slurry, preferably 0.01 to 1 mole. The flaky copper powder added with P at a content in the above range is preferable because it can easily obtain the highly oxidation resistance flaky copper powder. On the other hand, P content below 0.001 moles/mole is not preferable, because of insufficient oxidation resistance and difficultyinflatteningof the flaky copper powder. P content above 3 moles/mole is also not preferable because of excessively increased electric resistance of the powder.

The method of adding the second reducing agent to the second slurry, for example, the second reducing agent may be added in the form of aqueous solution in the second slurry kept stirred, the resulting solution being continuously stirred. When the second reducing agent is added in the second slurry in the fourth step, the solution is normally kept at 50 to 90°C, preferably 60 to 80°C. Keeping the solution at a temperature in the above range is preferable, because it can be produce of the highly uniformly-sized flaky copper particles, with the primary particles being efficiently prevented from agglomerating with each other.

The second reducing agent used in the present invention acts to reduce cuprous oxide (Cu₂O) in the second slurry into Cu. The second reducing agent is one or more selected for at least one selected from the group consisting of hydrazine, hydrated hydrazine (N₂H₄·H₂O), hydrazine sulfate, hydrazine carbonate and hydrazine chloride.

It is preferable to incorporate the second reducing agent in the first slurry slowly and little by little while taking substantial time rather than all at once, because it can be easy to keep diameter of the flaky copper particles within the range described above. Time for which it is added is normally 1 to 60 minutes, preferably 3 to 40 minutes.

In the fourth step, the second slurry is added with the second reducing agent normally at 0.5 to 6.0 moles per 1 mole of the copper salt present in the second slurry, preferably 0.8 to 3.0 moles. The second reducing agent present at content in the above range is preferable, because it allows the reduction of cuprous oxide (Cu₂O) into Cu to proceed sufficiently, thus it can be produce of the highly uniformly-sized flaky copper powder.

In the fourth step, the second slurry is stirred normally for 20 minutes to 2 hours, preferably 40 minutes to 1.5 hours, after it is added with the second reducing agent. Continued stirring of the solution added with the second reducing agent is preferable, because it sufficiently reduces cuprous oxide (Cu₂O) into Cu, thus it can be produce of the flaky copper powder with the primary particles agglomerating with each other to a lesser extent.

The fourth step produces the flaky copper powder in the slurry. The powder can be recovered by filtering the slurry by a Buchner funnel or the like, and rinse the precipitate with pure water and then rinsed with a methanol solution or the like containing oleic acid or the like and drying the precipitate. The mechanisms involved in production of the flaky copper powder only by reduction are not fully substantiated. However, it is noted that the powder is produced in the presence of phosphoric acid and its salt before the second reducing agent is added, based on which it is considered that phosphoric acid and its salt trigger some functions when cuprons oxide is reduced to copper to produce the flaky copper powder.

The organic surface layer, when provided on the flaky copper particles, may be formed by a known method, for example, dry or wet, by coating the particles with an organic compound.

### (Conductive paste of the present invention)

The conductive paste of the present invention is composed of the flaky copper powder of the present invention and a resin. The resins useful for the present invention include acrylic resin, epoxy resin, ethyl cellulose and carboxyethyl cellulose.

The conductive paste of the present invention contains the flaky copper powder of the present invention normally at 30 to 98wt%, preferably 40 to 90wt%. The paste containing the flaky copper powder in the above range is preferable, because it gives copper interconnections of low electrical resistance.

The flaky copper powder of the present invention can be used, either by itself or in combination with other spherical powder or the like, as a raw material for electrodes made by calcining or conductive paste. Moreover, it can give conductive paste in which the flaky copper powder is well dispersed, when mixed with a known paste used for production of conductive paste. The conductive paste can be used to secure conductive passages, e.g., in circuits on printed circuit substrate, external electrodes of ceramic condensers and or the like, and as a copper paste for measures against EMIs.

The present invention is described by Examples, which shall not be construed to limit the present invention.

### [Example 1]

Pure water (6 L) kept at 70°C was added with 4 kg of copper sulfate pentahydrate, 120 g of aminoacetic acid and 50 g of sodium phosphate with stirring, and the resulting aqueous solution was further added with pure water to 8 L and continuously kept stirred for 30 minutes.
Next, the aqueous solution was added, while it was kept stirred, with 5.8 kg of a 25wt% aqueous solution of sodium hydroxide, kept stirred for 30 minutes, and further added with 1.5 kg of glucose, and kept stirred for 30 minutes.
Then, the resulting aqueous solution was added, while it was kept stirred, with 1 kg of 100wt% hydrated hydrazine (N₂H₄·H₂O) slowly taking 5 minutes, and kept stirred for 1 hour to complete the reaction.
On completion of the reaction, the resulting slurry was filtered using a Buchner funnel, and the precipitate was rinsed with pure water and then rinsed with methanol, and dried to prepare the flaky copper powder.
The flaky copper powder was analyzed to measurements D₁₀, D₅₀, D₉₀, Dₘₐₓ, SD, crystallite diameter, P content and aspect ratio by the procedures described below. At the same time, SD/D₅₀ ratio and crystallite diameter/D_{1A} ratio were also calculated. The results are given in Tables 2 and 3.

### (Measurements of D₁₀, D₅₀, D₉₀, Dₘₐₓ and SD)

First, 0.2 g of the flaky copper powder sample was mixed with a 0.1 wt% aqueous solution of a dispersant (SN-Dispersant 5468, manufactured by Sannobuko co., Ltd.) and a nonionic surfactant (polyoxyethyleneoctylphenyl ether, Triton X-100, manufactured by Wako Pure Chemical Industries, Ltd.), and dispersed by a supersonic homogenizer (US-300T, manufactured by Nippon Seiki co. , Ltd.) for 5 minutes. Next, the particle diameters (µm) at cumulative volumes of 10, 50, 90 and 100% were determined by a laser diffraction/scattering analyzer (MicroTrack HRA9320-X100 Model, manufactured by Nikkiso Co. , Ltd., (manufactured by Leeds + Northrup co., Ltd.) to report them as D₁₀, D₅₀, D₉₀ and Dₘₐₓ. The standard deviation (SD, µm) was determined from the distribution particle size, obtained by the above analysis.

### (Determination of D_{1A})

The copper powder sample was directly observed by an SEM (magnification: 5,000 to 20,000), where the major diameter of the circular cross-section was measured for 200 particles to determine the average.

### (Determination of crystallite diameter)

The crystallite diameter was determined by an X-ray diffractometer (RINT200V, manufactured by Rigaku Corporation co., Ltd.) using a crystallite analysis software.

### (Analysis of P content)

The sample powder was dissolved in diluted nitric acid, and the solution was analyzed by an ICP emission analyzer to determine P content, from which P content in the powder was determined.

### (Determination of aspect ratio)

The average thickness (t, µm) of the particles was measured by a scanning electron microscope and the aspect ratio by is calculated dividing D_{1A} by the thickness t.

### [Example 2]

Pure water (6 L) kept at 70°C was added with 4 kg of copper sulfate pentahydrate, 120 g of aminoacetic acid and 75 g of sodium phosphate with stirring, and the resulting aqueous solution was further added with pure water to 8 L and continuously kept stirred for 30 minutes.
Next, the aqueous solution was added, while it was kept stirred, with 5.8 kg of a 25wt% aqueous solution of sodium hydroxide, kept stirred for 30 minutes, and further added with 1.5 kg of glucose, and kept stirred for 30 minutes.
Then, the resulting aqueous solution was added, while it was kept stirred, with 1 kg of 100 wt% hydrated hydrazine (N₂H₄·H₂O) slowly taking 30 minutes, and kept stirred for 1 hour to complete the reaction.
On completion of the reaction, the resulting slurry was filtered using a Buchner funnel, and the precipitate was rinsed with pure water and then rinsed with methanol and dried to prepare the flaky copper powder.
The flaky copper powder was analyzed to measure D₁₀, D₅₀, D₉₀, Dₘₐₓ, SD, crystallite diameter, P content and aspect ratio in the same manner as in Example 1. At the same time, SD/D₅₀ ratio and crystallite diameter/ D_{1A} ratio were also calculated. The results are given in Tables 2 and 3.
Moreover, the flaky copper powder prepared was subjected to thermogravimetric analysis (TG) by the following procedure, to determine oxidation initiation temperature. The result is given in Table 3.

### (Thermogravimetric analysis)

The flaky copper powder was heated in air at 10°C/minute to follow weight changes of the powder.

### [Example 3]

Pure water (6 L) kept at 70°C was added with 4 kg of copper sulfate pentahydrate, 120 g of aminoacetic acid and 75 g of sodium phosphate with stirring, and the resulting aqueous solution was further added with pure water to 8 L and continuously kept stirred for 30 minutes.
Next, the aqueous solution was added, while it was kept stirred, with 5.8 kg of a 25 wt% aqueous solution of sodium hydroxide, kept stirred for 30 minutes, and further added with 1.5 kg of glucose, and stirring was continued for 30 minutes.
Then, the resulting aqueous solution was added, while it was kept stirred, with 1 kg of 100 wt% hydrated hydrazine (N₂H₄·H₂O) slowly taking 30 minutes, and kept stirred for 1 hour to complete the reaction.
On completion of the reaction, the resulting slurry was filtered using a Buchner funnel, and the precipitate was rinsed with pure water and then with methanol. The filtration residue was immersed for one hour in a methanol solution which is obtained by dissolving 1 g of oleic acid in 3 L of methanol, and then rinsed with methanol and dried to prepare the flaky copper powder.
The resulting powder was put on filter paper placed on the Buchner funnel basal plane, to which a solution with 1 g of oleic acid dispersed in 1 L of methanol was added, allowed to stand for 30 minutes, and filtered under a vacuum by a vacuum pump.
The flaky copper powder left on the glass filter paper was taken out, dried at 70°C for 5 hours, to prepare the flaky copper powder coated with oleic acid.
The flaky copper powder was analyzed to measure D₁₀, D₅₀, D₉₀, Dₘₐₓ, SD, crystallite diameter, P content and aspect ratio in the same manner as in Example 1. At the same time, SD/D₅₀ ratio and crystallite diameter/ D_{1A} ratio were also calculated.
The results are given in Tables 2 and 3.

### [Example 4]

Pure water (6 L) kept at 70°C was added with 4 kg of copper sulfate pentahydrate and 120 g of aminoacetic acid, and the resulting aqueous solution was further added with pure water to 8 L and continuously kept stirred for 30 minutes.
Next, the aqueous solution was added, while it was kept stirred, with 75 g of sodium phosphate and then with 5.8 kg of a 25wt% aqueous solution of sodium hydroxide, kept stirred for 30 minutes, further added with 1.5 kg of glucose, and kept stirred for 30 minutes.
Then, the resulting aqueous solution was added, while it was kept stirred, with 1 kg of 100 wt% hydrated hydrazine (N₂H₄·H₂O) slowly taking 30 minutes, and kept stirred for 1 hour to complete the reaction.
On completion of the reaction, the resulting slurry was filtered using a Buchner funnel, and the precipitate was rinsed with pure water and then rinsed with methanol, and dried to prepare the flaky copper powder.
The flaky copper powder was analyzed to measure D₁₀, D₅₀, D₉₀, Dₘₐₓ, SD, crystallite diameter, P content and aspect ratio in the same manner as in Example 1. At the same time, SD/D₅₀ ratio and crystallite diameter/ D_{1A} ratio were also calculated. The results are given in Tables 2 and 3.
Moreover, the flaky copper powder prepared was subjected to thermogravimetric analysis (TG) in the same manner as in Example 2 to determine oxidation initiation temperature. The result is given in Table 3.

### [Example 5]

Pure water (6 L) kept at 70°C was added with 4 kg of copper sulfate pentahydrate, 120 g of aminoacetic acid with stirring, and the resulting aqueous solution was further added with pure water to 8 L and continuously kept stirred for 30 minutes.
Next, the aqueous solution was added, while it was kept stirred, with 5.8 kg of a 25wt% aqueous solution of sodium hydroxide, kept stirred for 30 minutes, added with 75 g of sodium phosphate and then with 1.5 kg of glucose, and kept stirred for 30 minutes.
Then, the resulting aqueous solution was added, while it was kept stirred, with 1 kg of 100wt% hydrated hydrazine (N₂H₄·H₂O) slowly taking 30 minutes, and kept stirred for 1 hour to complete the reaction.
On completion of the reaction, the resulting slurry was filtered using a Buchner funnel, and the precipitate was rinsed with pure water and then rinsed with methanol, and dried to prepare the flaky copper powder.
The flaky copper powder was analyzed to measure D₁₀, D₅₀, D₉₀, Dₘₐₓ, SD, crystallite diameter, P content and aspect ratio in the same manner as in Example 1. At the same time, SD/D₅₀ ratio and crystallite diameter/ D_{1A} ratio were also calculated.
The results are given in Tables 2 and 3.
Moreover, the flaky copper powder prepared was subjected to thermogravimetric analysis (TG) in the same manner as in Example 2 to determine oxidation initiation temperature. The result is given in Table 3.

### [Example 6]

Pure water (6 L) kept at 70°C was added with 4 kg of copper sulfate pentahydrate, 120 g of aminoacetic acid with stirring, and the resulting aqueous solution was further added with pure water to 8 L and continuously kept stirred for 30 minutes.
Next, the aqueous solution was added, while it was kept stirred, with 5.8 kg of a 25wt% aqueous solution of sodium hydroxide, kept stirred for 30 minutes, added with 1.5 kg of glucose, and kept stirred for 30 minutes.
Then, the resulting aqueous solution was added, while it was kept stirred, 75 g of sodium phosphate and then with 1 kg of 100wt% hydrated hydrazine (N₂H₄·H₂O) slowly taking 30 minutes, and kept stirred for 1 hour to complete the reaction.
On completion of the reaction, the resulting slurry was filtered using a Buchner funnel, and the precipitate was rinsed with pure water and then rinsed with methanol, and dried to prepare the flaky copper powder.
The flaky copper powder was analyzed to measure D₁₀, D₅₀, D₉₀, Dₘₐₓ. SD, crystallite diameter, P content and aspect ratio in the same manner as in Example 1. At the same time, SD/D₅₀ ratio and crystallite diameter/ D_{1A} ratio were also calculated.
The results are given in Tables 2 and 3.
Moreover, the flaky copper powder prepared was subj ected to thermogravimetric analysis (TG) in the same manner as in Example 2 to determine oxidation initiation temperature. The result is given in Table 3.

### [Comparative Example 1]

Pure water (6 L) kept at 70°C was added with 4 kg of copper sulfate pentahydrate, 120 g of aminoacetic acid with stirring, and the resulting aqueous solution was further added with pure water to 8 L and continuously kept stirred for 30 minutes.
Next, the aqueous solution was added, while it was kept stirred, with 5.8 kg of a 25 wt% aqueous solution of sodium hydroxide, kept stirred for 30 minutes, added with 1.5 kg of glucose, and kept stirred for 30 minutes.
Then, the resulting aqueous solution was added, while it was kept stirred, with 1 kg of 100wt% hydrated hydrazine (N₂H₄·H₂O) slowly taking 30 minutes, and kept stirred for 1 hour to complete the reaction.
On completion of the reaction, the resulting slurry was filtered using a Buchner funnel, and the precipitate was rinsed with pure water and then rinsed with methanol. The precipitate was immersed in a methanol solution obtained by dissolving 1 g of oleic acid in 3 L of methanol for one hour, and then rinsed with methanol and dried to prepare the copper powder.
The copper powder was ball milled in the presence of 0.7 mm zirconia beads as a medium and methanol as a solvent for 60 minutes using a mill (DYNO-MILL KDL, manufactured by Willy A. Bachofen AG Maschinenfabrik co., Ltd.) for plastic deformation of the copper powder.
The copper powder was analyzed to measure D₁₀, D₅₀, D₉₀, Dₘₐₓ, SD, crystallite diameter, P content and aspect ratio in the same manner as in Example 1. At the same time, SD/D₅₀ ratio and crystallite diameter/ D_{1A} ratio were also calculated. The results are given in Tables 2 and 3.
Moreover, the copper powder prepared was subjected to thermogravimetric analysis (TG) in the same manner as in Example 2 to determine oxidation initiation temperature. The result is given in Table 3.

**[Table 1]**

| | Pure water (L) | Copper sulfate pentahydrate (kg) | Aminoacetic acid (g) | sodium phosphate (g) | 25 wt% aqueous solution of sodium hydroxide (kg) | Glucose (kg) | 100 wt% hydrated hydrazine (kg) |
|---|---|---|---|---|---|---|---|
| Example 1 | 8 | 4 | 120 | 50 | 5.8 | 1.5 | 1 |
| Example 2 | 8 | 4 | 120 | 75 | 5.8 | 1.5 | 1 |
| Example 3 | 8 | 4 | 120 | 75 | 5.8 | 1.5 | 1 |
| Example 4 | 8 | 4 | 120 | 75 | 5.8 | 1.5 | 1 |
| Example 5 | 8 | 4 | 120 | 75 | 5.8 | 1.5 | 1 |
| Example 6 | 8 | 4 | 120 | 75 | 5.8 | 1.5 | 1 |
| Comparative Example 1 | 8 | 4 | 120 | 0 | 5.8 | 1.5 | 1 |

**[Table 2]**

| | Plastic deformation treatment | D₁₀ (µm) | D₅₀ (µm) | D₉₀ (µm) | Dₘₐₓ (µm) | D₉₀/D₁₀ | D_{IA} (µm) |
|---|---|---|---|---|---|---|---|
| Example 1 | Not employed | 0.72 | 1.02 | 1.46 | 10 | 2.03 | 1.2 |
| Example 2 | Not employed | 1.42 | 2.08 | 2.96 | 7 | 2.08 | 2.2 |
| Example 3 | Not employed | 1.41 | 2.10 | 2.99 | 7 | 2.12 | 2.3 |
| Example 4 | Not employed | 1.03 | 1.41 | 2.07 | 4 | 2.01 | 1.5 |
| Example 5 | Not employed | 0.92 | 1.24 | 1.76 | 4 | 1.91 | 1.3 |
| Example 6 | Not employed | 0.72 | 0.99 | 1.41 | 3 | 1.96 | 1.0 |
| Comparative Example 1 | Employed | 2.14 | 3.93 | 7.48 | 19 | 3.49 | 2.5 |

**[Table 3]**

| | SD (µm) | SD/D₅₀ | Crystallite diameter (nm) | Crystallite diameter/ D_{1A} | Aspect ratio | P content (ppm) | Oxidation initiation temperature |
|---|---|---|---|---|---|---|---|
| Example 1 | 0.26 | 0.25 | 44 | 0.037 | 5 | 55 | -^{*1} |
| Example 2 | 0.59 | 0.28 | 36 | 0.016 | 7 | 43 | 260 |
| Example 3 | 0.60 | 0.29 | 36 | 0.016 | 7 | 43 | -^{*1} |
| Example 4 | 0.37 | 0.26 | 38 | 0.025 | 6 | 46 | 250 |
| Example 5 | 0.31 | 0.25 | 40 | 0.031 | 6 | 33 | 230 |
| Example 6 | 0.26 | 0.26 | 39 | 0.039 | 5 | 29 | 230 |
| Comparative Example 1 | 2.01 | 0.51 | 19 | 0.008 | 6 | 0 | 180 |

| | | | | | | | |
|---|---|---|---|---|---|---|---|
| *1: Not measured | | | | | | | |

As shown in Tables 1 to 3, the flaky copper powder prepared from a raw material added with phosphoric acid and its salt is fine, sharp in particle size distribution, large in crystallite diameter, and can have a flaky shape without using plastic deformation treatment, as employed in COMPARATIVE Example 1. The smaller crystallite diameter observed in Comparative Example 1 results from plastic deformation treatment.

### Industrial Applicability

The present invention provides a flaky copper powder, a method for producing the same and a conductive paste, can be used for a copper paste or for material to the paste. The technology used for formationof electrical circuits onprinted circuit substrate and securing electrical continuity of external electrodes of ceramic condensers and or the like.

## Claims

1. A flaky copper powder which is **characterized in that** comprising P.

2. The flaky copper powder according to claim 1 which is **characterized in that** comprising P at 10 to 200 ppm.

3. The flaky copper powder according to claim 1 or 2, which is **characterized in that** an average particle diameter D₅₀ of the powder is in the range from 0.3 µm to 7 µm.

4. The flaky copper powder according to any one of claims 1 to 3, which is **characterized in that** crystallite diameter of the powder is 25 nm or more.

5. The flaky copper powder according to any one of claims 1 to 4 which is **characterized in that** an aspect ratio D_{1A/}t of the powder, which is calculated by dividing an average particle diameter D_{1A} (µm) by a flaky copper particle thickness t (µm), the average particle diameter D_{1A} (µm) and the thickness t (µm) are measured from analyzing SEM images directly observed by a scanning electron microscope, is in the range from 2 to 50.

6. The flaky copper powder according to any one of claims 1 to 5 **characterized by** having an SD/D₅₀ ratio of 0.45 or less, (where D₅₀ is a median diameter (µm) calculated as 50% of volume cumulative distributions examined by a laser diffraction scattering particle size distribution measuring method, and SD is a standard deviation (µm) of a particle size distribution examined by the same measuring method).

7. The flaky copper powder according to one of claims 1 to 6 which is **characterized in that** D₉₀/D₁₀ ratio of 3.0 or less, (where D₁₀ is diameter (µm) at 10% of volume cumulative distributions and D₉₀ is diameter (µm) at 90% of volume cumulative distributions examined by a laser diffraction scattering particle size distribution measuring method, and SD is a standard deviation (µm) of a particle size distribution examined by the same measuring method respectively).

8. A method for producing a flaky copper powder comprising four steps: a first step of preparing an aqueous solution comprising a copper salt and a complexing agent; a second step of adding an alkali hydroxide to the aqueous solution to prepare a first slurry comprising cupric oxide; a third step of adding a first reducing agent which can reduce cupric oxide into cuprous oxide to, the first slurry to prepare a second slurry comprising cuprous oxide; and a fourth step of adding a second reducing agent which can reduce the cuprous oxide into copper to the second slurry to provide a flaky copper powder, which is **characterized in that** phosphoric acid and its salt are added in at least one of the first to third steps and/or phosphoric acid and its salt are added in the second slurry in the fourth step.

9. The method for producing a flaky copper powder according to claim 8, which is **characterized in that** the phosphoric acid and its salt are added in at least one of the first to third steps and/or in the second slurry in the fourth step to be a total amount of 0.001 to 3 moles as P per 1 mole of copper which present in the above described aqueous solution, the first slurry or the second slurry.

10. The method for producing a flaky copper powder according to claim 8 or 9, which is **characterized in that** the first slurry contains the alkali hydroxide at 1.05 to 1.50 equivalents per equivalent of the copper salt.

11. The method for producing a flaky copper powder according to any one of claims 8 to 10, which is **characterized in that** the complexing agent is an amino acid.

12. The method for producing a flaky copper powder according to any one of claims 8 to 11, which is **characterized in that** the first reducing agent is a reducing sugar.

13. The method for producing a flaky copper powder according to any one of claims 8 to 12, which is **characterized in that** the second reducing agent is at least one selected from the group consisting of hydrazine, hydrated hydrazine, hydrazine sulfate, hydrazine carbonate and hydrazine chloride.

14. The method for producing a flaky copper powder according to any one of claims 8 to 13, which is **characterized in that** the aqueous solution comprises the complexing agent at 0.005 to 10 moles per 1 mole of copper present in the aqueous solution itself, the first slurry or the second slurry.

15. The flaky copper powder according to any one of claims 1 to 7, which is **characterized in that** an organic surface treatment layer is formed on the surface.

16. The flaky copper powder according to claim 15, which is **characterized in that** a coating rate of the organic surface treatment layer is 0.05 to 2wt% based on the flaky copper powder.

17. A conductive paste which is **characterized in that** comprising the flaky copper powder according to any one of claims 1 to 7, and claims 15 and 16 and a resin.
